(19) Europäisches Patentamt
European Patent Office
Office européen des brevets

(11) **EP 4 465 060 B1**

(12) **EUROPEAN PATENT SPECIFICATION**

(45) Date of publication and mention
of the grant of the patent:
**14.01.2026  Bulletin 2026/03**

(21) Application number: **24176710.2**

(22) Date of filing: **17.05.2024**

(51) International Patent Classification (IPC):
**G01R 31/3835** *(2019.01)*    **G01R 31/392** *(2019.01)*
**G01R 31/396** *(2019.01)*

(52) Cooperative Patent Classification (CPC):
**G01R 31/396; G01R 19/16542; G01R 31/3835;
G01R 31/392;** Y02E 60/10

## (54) DEVICE AND METHOD FOR DETECTING ABNORMAL BATTERY CELL

VORRICHTUNG UND VERFAHREN ZUR ERKENNUNG EINER ABNORMALEN BATTERIEZELLE

DISPOSITIF ET PROCÉDÉ DE DÉTECTION D'ÉLÉMENT DE BATTERIE ANORMAL

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **19.05.2023   KR 20230065164**

(43) Date of publication of application:
**20.11.2024   Bulletin 2024/47**

(73) Proprietor: **Samsung SDI Co., Ltd.**
**Yongin-si, Gyeonggi-do 17084 (KR)**

(72) Inventor: **NAM, Kyunghoon**
**17084 Yongin-si (KR)**

(74) Representative: **Marks & Clerk LLP**
**15 Fetter Lane**
**London EC4A 1BW (GB)**

(56) References cited:
CN-A- 113 156 318       KR-U- 20200 000 793
US-A1- 2022 026 499     US-A1- 2022 376 314

**Description**

BACKGROUND

<u>(a)</u> <u>Field</u>

The present disclosure relates to an abnormal cell detection device and a method therefor.

<u>(b)</u> <u>Description of the Related Art</u>

An energy storage system (ESS) is a system that improves energy use efficiency by storing large capacity electrical energy and supplying the stored electrical energy when electrical energy is needed.

In general, the ESS may include a battery system, a battery management system (BMS) that manages the battery system, such as monitoring a voltage, a current, a temperature, and the like of the battery system, a power conversion system (PCS) that performs AC-DC conversion and distribution functions, an energy management system (EMS) that controls energy flow of the ESS and collects and manages information on the state of the ESS, and the like.

In addition, the battery system may include a plurality of battery racks that are electrically connected with each other. Each battery rack includes a plurality of battery modules that are electrically connected to each other, and each battery module may include a plurality of cells that are electrically connected to each other.

Battery cells may experience events such as internal foreign particles, internal short circuits, and deterioration, which may cause safety problems such as thermal runaway and ignition. The resulting abnormal cells may cause fires in the energy storage system. Therefore, early detection of abnormal cells in energy storage systems is a very important issue.

CN 113 156 318 A describes a fault cell detection method and device, an electronic device and a storage medium. The method is used for detecting a fault cell in a battery system comprising a plurality of cells. The method comprises: acquiring a voltage value of each cell; determining the voltage difference between each voltage value and a minimum voltage value, the minimum voltage value being the minimum value in the voltage values; and determining a fault cell in the battery system according to the voltage differences corresponding to the plurality of cells.

US 2022/026499 A1 describes a method and a system for monitoring the health condition of a battery pack. The method includes: obtaining data of voltage difference between the maximum and minimum voltages of the battery cells within a battery pack of an electric vehicle; determining an alert value based on the data of voltage difference, wherein the alert value is a combined value of the following factors: the slope of the mean battery cell voltage difference within a preset period of past time, the predicted mean battery cell voltage difference within a preset period of future time, and the minimum of battery cell voltage difference; generating a predictive maintenance notice for the battery pack of the electric vehicle when the alert value is larger than a threshold value.

US 2022/376314 A1 describes a method for detecting a fault state of at least one battery cell of a battery having multiple battery cells. A cell voltage of a respective battery cell of the multiple battery cells is registered at a measurement time and a comparison value is determined as a function of at least one of the cell voltages and is compared to a provided first reference value. The fault state is detected as a function of a result of the comparison. A scatter value is determined, which represents a scatter of at least part of the cell voltages registered at the specific measurement time, and the fault state is determined as a function of the scatter value.

KR 2020 0000793 U describes a device for extending the life of a lithium battery and for remote failure testing. The lithium battery life extension and remote failure test device includes: a battery voltage measurement unit that measures the voltage of each cell of a battery including a plurality of cells; and a battery monitoring control unit that receives the voltage of each cell from the battery voltage measurement unit, determines whether it corresponds to a battery failure condition, and performs a battery failure test.

SUMMARY

Embodiments include an abnormal cell detection device and method that can detect abnormal cells in advance before problems due to abnormal cells occur in an energy storage system.

An abnormal cell detection device according to an embodiment includes: a storage device that stores cell voltage values detected for each rest period after discharge from a battery bank including a plurality of battery racks, and a control device configured to determine a maximum cell voltage value and a first minimum cell voltage value in each battery rack for each rest period, determine a first difference value between the maximum cell voltage value and the first minimum cell voltage value in each battery rack for each rest period, select a target battery rack by statistically analyzing a change in the first difference value during a predetermined period, determine a second difference value between an average cell voltage value and a second minimum cell voltage value in each battery module of the target battery rack for each rest period, and

determine a battery module including an abnormal cell in the target battery rack based on the second difference value.

The control device may be further configured to determine a first change amount of the first difference value by comparing with the previous rest period for each rest period, and calculate a second change amount in the first difference value during the predetermined period by cumulatively summing the first change amount determined for each rest period.

The control device may be further configured to apply a weight value to the first change amount depending on whether the first change amount increases or decreases when cumulatively summing the first change amount, and calculate the second change amount by cumulatively summing the first change amount to which the weight value is applied.

The control device may be further configured to determine a sigma of the second change amount for each battery rack based on the second change amount, an average value of the second change amount and a standard deviation of the second change amount of the plurality of battery racks during the predetermined period, and determine a battery rack of which the sigma satisfies a predetermined condition as the target battery rack.

The control device may be further configured to exclude, from a selection of the target battery rack, a battery rack in which the first minimum cell voltage value is not detected in the same battery cell during the predetermined period.

The control device may be further configured to perform a linear regression analysis of the change in the first minimum cell voltage value for each battery rack during the predetermined period, and exclude, from a selection of the target battery rack, a battery rack of which a slope of the first minimum cell voltage value determined by the linear regression analysis does not satisfy a predetermined condition.

The control device may be further configured to divide the entire output range of a battery cell into a plurality of voltage ranges, select a corresponding voltage range for each battery module in the target battery rack among the plurality of voltage ranges for each rest period, if a number of rest periods in which the same voltage range is selected among rest periods occurred during the predetermined period is greater than or equal to a predetermined value, select rest periods in which the same voltage range is selected as a valid rest period, and determine a battery module including the abnormal cell based on the second difference value of the valid rest period.

The control device may be further configured to determine a voltage range in which the average cell voltage value of each battery module belongs among the plurality of voltage ranges as the corresponding voltage range of each battery module.

The average cell voltage value of each battery module may be an average value of remaining cell voltage values excluding the second minimum cell voltage value among cell voltage values detected in each battery module.

The control device may be further configured to perform a linear regression analysis of the change in the second difference value for each battery module of the target battery rack during the predetermined period, and determine a battery module in which a slope of the second difference valuedetermined by the linear regression analysis satisfies a predetermined condition as a battery module including the abnormal cell.

The control device may be further configured to determine a battery cell in which the second minimum cell voltage value is detected within the battery module including the abnormal cell as the abnormal cell.

The control device may be further configured to exclude a battery module in which the battery cell of which the second minimum cell voltage value is detected is not the same during the predetermined period from abnormal cell detection. The rest period may be a rest period after discharge, and the cell voltage values may be values detected after a predetermined time after the rest period begins.

An abnormal cell detection method according to an embodiment includes:
acquiring cell voltage values of each battery rack included in a battery bank in each rest period after discharge of the battery bank, determining a maximum cell voltage value and a first minimum cell voltage value in each battery rack for each rest period, determining a first difference value between the maximum cell voltage value and the first minimum cell voltage value in each battery rack for each rest period, selecting a target battery rack by statistically analyzing a change in the first difference value over a predetermined period, determining a second difference value between an average cell voltage value and a second minimum cell voltage value in each battery module of the target battery rack for each rest period, and determining a battery module including an abnormal cell in the target battery rack based on the second difference value.

The selecting the target battery rack may include: determining a first change amount of the first difference value by comparing with the previous rest period for each rest period; calculating a second change amount of the first difference value during the predetermined period by cumulatively summing the first change amount determined for each rest period; calculating an average value and a standard deviation of the second change amount for a plurality of battery racks included in the battery bank for the predetermined period; determining a sigma of the second change amount for each battery rack based on an average value of the second change amount, the standard deviation of the second change amount, and the second change amount; and determining a battery rack of which the sigma satisfies a predetermined condition as the target battery rack.

The calculating the second change amount may include applying a weight value to the first change amount according to whether the first change amount increases or decreases, and calculating the second change amount by cumulatively summing the first change amount to which the weight value is applied.

The abnormal cell detection method may further include excluding, from a selection of the target battery rack, a battery rack in which the first minimum cell voltage value is not detected from the same battery cell during the predetermined period.

The abnormal cell detection method may further include: performing a linear regression analysis of the change in the first minimum cell voltage value for each battery rack during the predetermined period; and excluding, from a selection of the target battery rack, a battery rack of which a slope of the first minimum cell voltage value determined by the linear regression analysis does not satisfy a predetermined condition.

The determining the second difference value may include: selecting, for each battery module in the target battery rack, a corresponding voltage range among a plurality of voltage ranges divided at predetermined intervals for each rest period; if a number of rest periods in which the same voltage range is selected among rest periods occurred during the predetermined period is greater than or equal to a predetermined value, selecting rest periods in which the same voltage range is selected as a valid rest period; and determining a battery module including the abnormal cell based on the second difference value of the valid rest period.

The selecting the corresponding voltage range may include determining a voltage range in which the average cell voltage value of each battery module belongs among the plurality of voltage ranges as the corresponding voltage range of each battery module.

The average cell voltage value of each battery module may be an average value of remaining cell voltage values excluding the second minimum cell voltage value among cell voltage values detected in each battery module.

The abnormal cell detection method may further include: performing a linear regression analysis of the change in the second difference value for each battery module of the target battery rack during the predetermined period; and determining a battery module in which a slope of the second difference value determined by the linear regression analysis satisfies a predetermined condition as a battery module including the abnormal cell.

The abnormal cell detection method may further include determining a battery cell in which the second minimum cell voltage value is detected within the battery module including the abnormal cell as the abnormal cell.

The abnormal cell detection method may further include excluding a battery module in which the battery cell of which the second minimum cell voltage value is detected is not the same during the predetermined period from abnormal cell detection.

According to the present disclosure, safety problems caused by abnormal cells can be prevented by early detection of abnormal cells in the energy storage system.

At least some of the above and other features of the invention are set out in the claims.

BRIEF DESCRIPTION OF THE DRAWINGS

FIG. 1 schematically illustrates an energy storage system according to an embodiment.

FIG. 2 schematically illustrates an abnormal cell detection device of the ESS according to an embodiment.

FIG. 3 is a graph provided for description of a correlation between the abnormal cell occurrence and the minimum cell voltage value of the battery rack.

FIG. 4 is a graph provided for description of a correlation between the abnormal cell occurrence and a sigma of the battery rack.

FIG. 5 is a graph illustrating a cell voltage change in a battery module in which an abnormal cell is occurred, and a change in the difference value between the average cell voltage value and the minimum cell voltage value.

FIG. 6 is a flowchart of an abnormal cell detection method of the ESS according to an embodiment.

FIG. 7 is a detailed flowchart of the step S13 of FIG. 6.

DETAILED DESCRIPTION

Hereinafter, embodiments of the present disclosure will be described in detail with reference to the attached drawing. Hereinafter, the effects and features of the embodiments and their implementation methods will be described in detail with reference to the attached drawings. In the drawings, the same reference sign indicates the same constituent element, and redundant description thereof is omitted. However, the present invention may be implemented in various forms and should not be construed as being limited to the example embodiments described herein. Rather, these embodiments are provided as examples so that the present invention is thoroughly and completely understood, and will fully convey the aspects and features of the present invention to those skilled in the art.

Accordingly, the description may not describe any processes, elements or techniques deemed not necessary to those skilled in the art for the thorough understanding of the aspects and features of the present invention. The drawings may exaggeratedly show relative sizes of elements, layers and regions for clarity.

The term "and/or" in this specification may include all combinations or any combination of a plurality of related listed items. Usage of "may" or "may be" in describing the example embodiments of the present invention may indicate "may" or "may be" in "one or more example embodiments of the present invention."

In the following description of the example embodiments of the present invention, a term in a singular form may include its plural form unless the context clearly indicates otherwise.

In this specification, terms including ordinal numbers such as "first," "second," "third" and the like are used to describe various components. However, these components are not limited by these terms. These terms are used only to distinguish one component from another component. For example, a 'first' component may be named a 'second' component and the 'second' component may also be similarly named the "first" component, without departing from the scope of the present invention.

In this specification, when one component or layer is described as being "on, " "connected to, " or "coupled to" another component or layer, it may be "directly on" another component or layer or "connected to" and "coupled to" another component or layer interposing one or more other components or layers. In addition, when a component or layer is described as being "between" two components or layers, it should be understood as only one component or layer between the two components or layers, or one or more other components or layers interposed between the same.

In the present specification, "electrically connecting" two constituent elements may include not only connecting two constituent elements directly, but also connecting two constituent elements through another constituent element. Other constituent elements may include switches, resistors, capacitors, and the like. When describing embodiments, the expression "connect" means to connect electrically, if there is no expression to connect directly.

Hereinafter, an abnormal cell detection device and a method of an energy storage system (ESS) will be described in detail with reference to the necessary drawings.

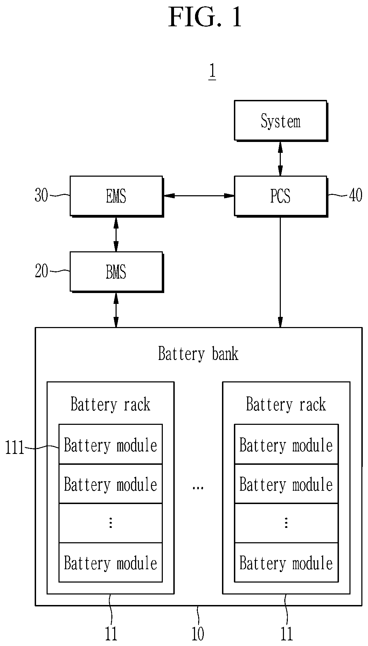

FIG. 1 schematically illustrates an energy storage system according to an embodiment.

Referring to FIG. 1, an ESS 1 according to an embodiment may include a battery bank 10, a battery management system (BMS) 20, an energy management system (EMS) 30, and a power conversion system (PCS) 40.

The battery bank 10 may include a plurality of battery cells (not shown) that are connected in series or in parallel with each other. For example, the battery bank 10 may include a plurality of battery racks 11 that are electrically connected in series or in parallel with each other. In addition, each battery rack 11 may include a plurality of battery modules 111 that are electrically connected in series or in parallel with each other. In addition, each battery module 111 may include a plurality of battery cells (not shown) that are electrically connected in series or in parallel with each other.

The battery bank 10 may charge battery cells using electrical energy supplied from a power system (not shown) through the PCS 40. In addition, the PCS 40 may supply electrical energy stored in the battery cells to the power system through the PCS 40.

The PCS 40 may operate as a power conversion device that converts one or more electrical characteristics (e.g., DC, AC, a voltage, a frequency, etc.) to transfer electrical energy between the battery bank 10 and the power system. Typically, electrical energy in the form of DC is used in the battery bank 10, and electrical energy in the form of AC is used in the power system. Therefore, the PCS 40 transmits electrical energy stored in the battery bank 10 to the power system through DC-AC conversion, or transmits electrical energy supplied from the power system to the battery bank 10 through AC-DC conversion.

In addition to the power conversion and distribution functions described above, the PCS 40 may also perform electrical quality control functions such as active power and reactive power of the ESS 1. The PCS 40 may also perform a monitoring/control function that monitors the voltage and operating status of the ESS 1. The PCS 40 may also perform a system-connected protection function that protects the power system during power outages. The PCS 40 may also perform independent operation functions such as driving the ESS 1 using the battery bank 10 even if there is no power source.

The battery bank 10 may be managed by the BMS 20. The BMS 20 may monitor the status of the battery bank 10 and control the battery bank 10 to operate in an optimal state. For this purpose, the BMS 20 may perform, for the battery cells included in the battery bank 10, a status monitoring function (e.g., monitoring of cell voltage, current, temperature, state of charge (SOC), state of health (SOH), etc.), a control function (e.g., temperature control, cell balancing control, etc.), and a protection function (e.g., prevention of overdischarge, overcharge, overcurrent, etc.).

The BMS 20 may collect data related to the status of the battery cells from the battery bank 10 in order to monitor the status of the battery bank 10. The battery racks 11 together may constitute the battery bank 10 and may collect data related to the status of the battery cells from the battery modules 111 where they belong, and transmit the collected data to the BMS 20. The battery racks 11 constituting the battery bank 10 may transmit and receive data through a daisy chain method, and communicate with other battery racks) 11 or the BMS 20 using, in an example embodiment, controller area network (CAN) communication.

The EMS 30 is an integrated control device that monitors and controls the power use of the power system and the power supply of the ESS 1 in real time for efficient energy operation of the ESS 1. The EMS 30 may monitor the status of the entire system (i.e., the battery bank 10, the BMS 20, and the PCS 40) that form the ESS 1, and may control driving of the ESS 1.

In order to monitor the status of the battery bank 10 and the BMS 20, the EMS 30 may receive rack data collected from the battery bank 10 and BMS data that indicates the status of the BMS 20 from the BMS 20.

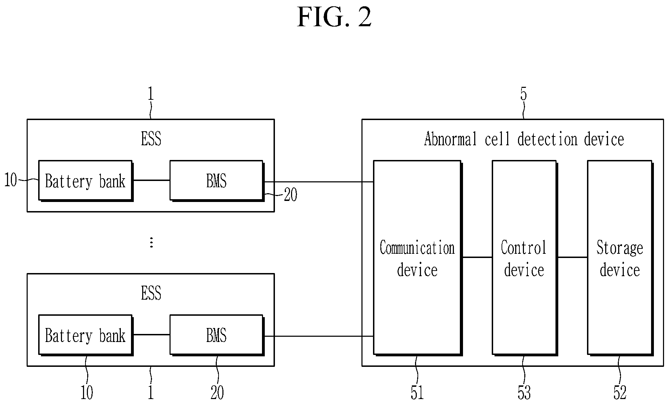

FIG. 2 schematically illustrates an abnormal cell detection device of the ESS according to an embodiment.

Referring to FIG. 2, an abnormal cell detection device 5 according to an embodiment may include a communication device 51, a storage device 52, and a control device 53.

The communication device 51 may perform a wired and wireless communication function between the abnormal cell detection device 5 and one or more ESSs 1.

The storage device 52 may store log data collected from each ESS 1. The log data may include a cell voltage value collected from each battery bank 10 constituting the ESS 1.

Due to the operation characteristics of the ESS 1, at least 1 cycle of charge and discharge periods is performed for the battery bank 10 every day. In addition, the ESS 1 is operated to have a rest period after the charging period and/or after the discharge period.

For the diagnosis of abnormal cells, the BMS 20 of each ESS 1 may collect cell voltage values of the battery cells measured in the rest period after the discharge period of the battery bank 10. A managing device (e.g., module BMS) may manage each battery module 111, together constituting the battery bank 10, may measure a voltage value of a plurality of battery cells included in the battery module 111 during the rest period after the discharge period. Each battery module 111 may acquire a cell voltage value by measuring a cell voltage after a predetermined time (e.g., 20 minutes) has elapsed from the starting point of the rest period in order to acquire voltage data close to an open circuit voltage (OCV) for each battery cell.

The cell voltage values measured from each battery module 111 in the rest period after discharge are grouped for each battery module 111, and then may be grouped again for each battery rack 11 and transmitted to the BMS 20. After grouping the collected cell voltage values for each battery bank 10, the BMS 20 may transmit the grouped cell voltage value to the abnormal cell detection device 5 as log data. When transmitting the cell voltage values of the battery bank 10 to the abnormal cell detection device 5, the BMS 20 may transmit the cell voltage values by directly communicating with the abnormal cell detection device 5, or may transmit the cell voltage values to the abnormal cell detection device 5 through the EMS 30.

In embodiments, the rest period after discharge from the ESS 1 may occur once a day, and the BMS 20 may repeat the task of collecting cell voltage values every day and transmitting the collected cell voltage value to the abnormal cell detection device 5.

The control device 53 may store and manage cell voltage values received from each ESS 1 as log data. When receiving the cell voltage values from each ESS 1, the control device 53 may categorize cell voltage values by the ESS 1 and store them in the storage device 52. To prevent false detections due to deviations in operating conditions, abnormal cell detection may be performed with on a per the battery bank 10 operating in the same environment. To prevent false detections due to deviations in operating conditions, abnormal cell detection may be performed with 10 units of the battery bank 10 operating in the same environment. The control device 53 may monitor the cell voltage values of the battery bank 10 over a long period of time to detect abnormal cells. Therefore, when receiving cell voltage values, the control device 53 may map cell voltage values to the corresponding battery bank 10 and store them in the storage device 52 in time series (i.e., by date).

The control device 53 may statistically analyze a voltage change of a battery cell based on the log data collected for each battery bank 10, and detect abnormal cell occurrence based on the analysis result.

The abnormal cell detection of the control device 53 may be divided into a primary detection process and a secondary detection process.

The primary detection process is a process to preferentially determine the battery rack 11, which is determined to be likely to generate abnormal cells, among the battery racks 11 of the battery bank 10, and is a process for reducing the amount of computation by reducing transient detection. The control device 53 may perform the secondary detection process for a battery rack 11 selected in the primary detection process.

In the primary detection process, the control device 53 may determine a range value (Vmax-min) of the cell voltage values for each rest period (or per day) with respect to each battery rack 11. The range value (Vmax-min) of the cell voltage values implies a difference value between a maximum cell voltage value (Vmax) and a minimum cell voltage value (Vmin) among cell voltage values detected during a corresponding rest period. If the range value (Vmax-min) of each battery rack 11 is calculated for each rest period, the control device 53 may perform statistical analysis to monitor changes in the range value (Vmax-min) of each battery rack 11 for a predetermined period (hereinafter, referred to as a data collection period).

For analyzing a behavior of the range value (Vmax-min) of each battery rack 11, the control device 53 may calculate a change amount of a range value (Vmax-min) of each battery rack 11 for each rest period (or per day). That is, the control device 53 may calculate a change amount of a range value for each rest period (or per day) by subtracting a range value (V'max-min) calculated from the previous rest period (i.e., rest period of the previous day) from the range value (Vmax-min) calculated from the current rest period (rest period of today). In addition, the control device 53 cumulatively adds up the calculated range value change for each rest period for each battery rack 11 during the data collection period, as shown in Equation 1 below, to calculate the range value change (ΔVmax-min) during the data collection period of each battery rack 11.

$$\text{Equation 1:}$$

$$\triangle \text{Vmax-min} = \text{SUM} \left( w \times (\text{Vmax-min} - \text{V'max-min}) \right)$$

**In** Equation 1, w is a weight value, and may be determined according to a range value change amount (Vmax-min - V'max-min) in each rest period. In an implementation, if (Vmax-min - V'max-min) > 0, w may become 1, and if (Vmax-min - V'max-min) < 0, w may become less than one, e.g., 0.7. That is, when calculating the range value change amount (ΔVmax-min) during the data collection period, the control device 53 may set a weight value such that a reflection ratio of a case (Vmax-min - V'max-min) > 0) that the range value (Vmax-min) increases higher than the range value (V'max-min) of the previous rest period is higher than a reflection ratio of a case (Vmax-min - V'max-min) < 0) that the range value (Vmax-min) decreases lower than the range value (V'max-min) in the previous rest period.

Table 1 shows an example of the maximum and minimum cell voltage values collected during the data collection period (March 1st - March 3rd) for one battery rack 11.

Table 1

| Date | Maximum cell voltage value (Vmax) [mV] | Minimum cell voltage value (Vmin) [mV] | Range value (Vmax-min) [mV] |
|---|---|---|---|
| March 1st | 3200 | 3150 | 50 |
| March 2nd | 3180 | 3100 | 80 |
| March 3rd | 3200 | 3130 | 70 |

If the data in Table 1 above is substituted into Equation 1 above, the change in range value (ΔVmax-min) of the corresponding battery rack 11 during the data collection period (March 1st - March 3rd) becomes ($1 \times$ (80 - 50) + $0.7 \times$ (70 - 80)) = 23.

If the range value change amount (△Vmax-min(i)) during the data collection period for each battery rack 11 is calculated, the control device 53 may calculate a sigma of the range value change amount for each battery rack 11 using an average value and a standard deviation of the range value change amount (△Vmax-min(i)) of all the battery racks 11 included in battery bank 10. The sigma of the range value change amount of the battery rack 11 is a value that represents the degree to which the range value change amount (△Vmax-min(i)) of the battery rack 11 deviates from an average range value change amount of the battery bank 10 to which the battery rack 11 is included. The control device 53 may calculate the sigma of the range value change amount for an i-th battery rack 11 using Equation 2 below.

Sigma (i) of range value change amount = (△Vmax-min(i) - AVG(△Vmax-min 1, △Vmax-min 2, ..., △Vmax-min(N)))/STDEV(△Vmax-min 1, △Vmax-min 2, ..., △Vmax-min(N))

Equation 2:

Equation 2 may be used to calculate the sigma (i) of the range value change amount for the i-th battery rack 11 among N battery racks 11 that form the battery bank 10. In Equation 2, AVG(△Vmax-min 1, △Vmax-min 2, ..., △Vmax-min(N))) and STDEV(△Vmax-min 1, △Vmax-min 2, ..., △Vmax-min(N)) respectively represent the average value and standard deviation of the range value change amount (△Vmax-min) for the entire battery rack 11 constituting the battery bank 10.

If the sigma of the range value change during the data collection period is calculated for each battery rack 11 that forms the battery bank 10, the control device 53 may select a battery rack 11, which may be determined to be likely to generate abnormal cells, as a secondary detection target based on the calculated sigma. For example, the control device 53 may select a battery rack 11, where the sigma of the range value change is greater than 4, as the secondary detection target.

To reduce over-detection, the control device 53 may perform cross-verification on the battery rack 11, which may be selected as a secondary detection target, based on the minimum cell voltage value detected in each battery rack 11.

If the same battery cell does not satisfy the condition of maintaining the minimum cell voltage value within the battery rack 11 throughout the data collection period, the control device 53 may exclude the battery rack 11 from secondary detection regardless of the sigma value. In other words, the control device 53 may select only a battery rack 11, where the same battery cell maintained the minimum cell voltage value within the battery rack 11, as the secondary detection target according to the sigma value throughout the data collection period.

In addition, the control device 53 may perform linear regression analysis on the change in the minimum cell voltage value (Vmin) detected in the battery rack 11 during the data collection period to approximate the change in the minimum cell voltage value (Vmin) over time using the slope of a linear function. If the slope calculated in this way is a negative value, it means that the minimum cell voltage value shows a voltage behavior that gradually decreases during the data collection period. If the slope calculated in this way does not satisfy a predetermined condition (e.g., the condition of slope < -0.4), the control device 53 may exclude the battery rack 11 from the secondary detection target regardless of the sigma value. That is, the control device 53 may select only a battery rack 11 of which the slope of the minimum cell voltage value (Vmin) calculated through the linear regression analysis during the data collection period satisfies the predetermined condition (e.g., the condition of slope < -0.4) as a secondary detection target according to a sigma value.

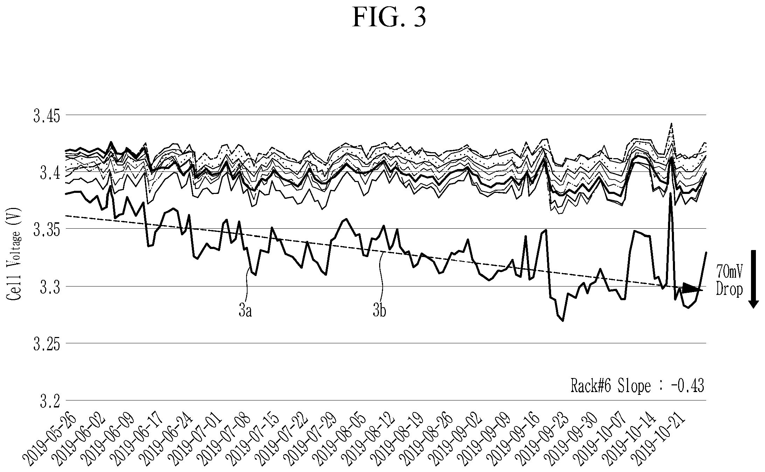

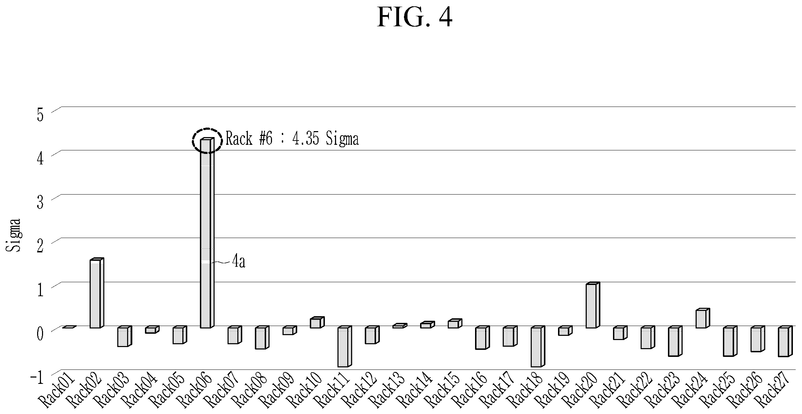

FIG. 3 is a graph describing a correlation between the abnormal cell occurrence and the minimum cell voltage value (Vmin) of the battery rack. FIG. 4 is a graph describing a correlation between the abnormal cell occurrence and a sigma of the battery rack, and it illustrates a case that an abnormal cell is generated in Rack #6.

Referring to FIG. 3, the minimum cell voltage value 3a of Rack #6 where an abnormal cell occurred gradually decreases over time, and when detected on October 21, 2019, it was about 70 mV lower than when detected on May 26, 2019. In addition, when the change in the minimum cell voltage value 3a from May 26, 2019 to October 21, 2019 is approximated by the linear function 3b, the slope of -0.43 can be approximated by the linear function 3b.

In addition, referring to FIG. 4, it can be observed that when calculating the sigma value for the cell voltage values collected from May 26, 2019 to October 21, 2019 using Equation 2 above, the sigma 4a of Rack #6 where the abnormal cell occurred is 4.35, which is a large value compared to other battery racks.

Therefore, the control device 53 may identify the battery rack 11 where abnormal cells are estimated to occur based on the sigma value and the slope of the minimum cell voltage value 3a over time.

If the battery rack 11, which is the secondary detection target, is determined in the above-described manner, the control device 53 may perform a secondary detection process to detect abnormal cells in the battery module 111 constituting the battery rack 11.

In the secondary detection process, the control device 53 may select a valid rest period to be used for abnormal cell detection among the rest periods that occurred during the data collection period for each battery module 111. Due to the characteristics of the battery cell, if the SOC is low, the cell voltage may rapidly decrease. Due to such a phenomenon, cell voltages of a plurality of battery cells within the battery module 111 may drop all at once. Therefore, in order to prevent false detection due to such a phenomenon, the control device 53 may exclude the rest period during which a voltage drop is determined to have occurred in a plurality of battery cells due to low SOC from the linear regression analysis.

To determine a valid rest period, the control device 53 may set a plurality of voltage ranges by dividing the entire voltage range that the battery cell can output into predetermined intervals. For example, the control device 53 may set the plurality of voltage ranges by dividing the entire output voltage range of the battery cell into 1 0mV intervals. In addition, the control device 53 may determine a voltage range corresponding to each rest period (or each day) for each battery module 111. A minimum cell voltage value detected in each rest period is likely to be a voltage value of an abnormal cell. Therefore, when determining a voltage range corresponding to each rest period, the control device 53 may determine a voltage range using cell voltage values excluding a minimum voltage value among cell voltage voltages detected during the respective rest periods. That is, the control device 53 may calculate an average cell voltage value using cell voltage values other than a minimum voltage value for each rest period (or per date) for each battery module 111. In addition, the control device 53 may determine a voltage range corresponding to each rest period (or date) by checking which voltage range the calculated average cell voltage value for each rest period (or date) belongs to.

If the voltage range corresponding to each rest period (or date) is determined, the control device 53 may group rest periods (or dates) included in the same voltage range as the same voltage group. Then, if there is a voltage group in which more than 50 % of the entire rest periods that occurred during the data collection period are included, the control device 53 may select the rest periods included in the corresponding voltage group as a valid rest period subject to linear regression analysis. In addition, the control device 53 may exclude the remaining rest periods that are not selected as valid rest periods from the linear regression analysis.

For example, if the average cell voltage value (excluding the minimum cell voltage value) detected by the battery module 111 for each rest period for a data collection period (March 1st to March 7th) are respectively 3130mV (March 1st), 3131mV (March 2nd), 3133mV (March 3rd), 3120mV (March 4th), 3139mV (March 5th), 3140mV (March 6th), 3135mV (March 7th), and may group rest periods conducted on March 1st, March 2nd, March 3rd, March 5th, and March 7th, excluding March 4th and March 6th, into the same voltage group (3130mV to 3139mV). In addition, the control device 53 may select the rest periods of March 1st, March 2nd, March 3rd, March 5th, and March 7th grouped in the same voltage group 3130mV to 3139mV as valid rest periods, which are subjected to the linear regression analysis, and may exclude the rest periods of March 4th and March 6th from the target of the linear regression analysis.

If a valid rest period for each battery module 111 is determined, the control device 53 may calculate a difference value (Vavg-min) between an average cell voltage value (Vavg) and a minimum cell voltage value (Vmin) of cell voltage values for each valid rest period. In this case, the average cell voltage value (Vavg) may be a value calculated by including the minimum cell voltage value (Vmin), or may be a value calculated only using other cell voltage values excluding the minimum cell voltage value (Vmin).

If the difference value (Vavg-min) for the valid rest period is calculated, the control device 53 may perform the linear regression analysis. That is, the control device 53 may calculate a slope representing a change rate of the difference value (Vavg-min) by approximating the change in the difference value (Vavg-min) over time for each battery module 111 with a linear function. If the slope calculated in this way is greater than 0, it means that the difference value (Vavg-min) between the average cell voltage value (Vavg) and the minimum cell voltage value (Vmin) gradually increases, and thus, cell voltages of only battery cells with the minimum cell voltage value detected are gradually decreased. Thus, if the slope of the difference value (Vavg-min) acquired through the linear regression analysis is greater than 0.4, the control device 53 may determine that an abnormal cell has occurred within the battery module 111, and determine the battery cell for which the minimum cell voltage value is detected to be an abnormal cell.

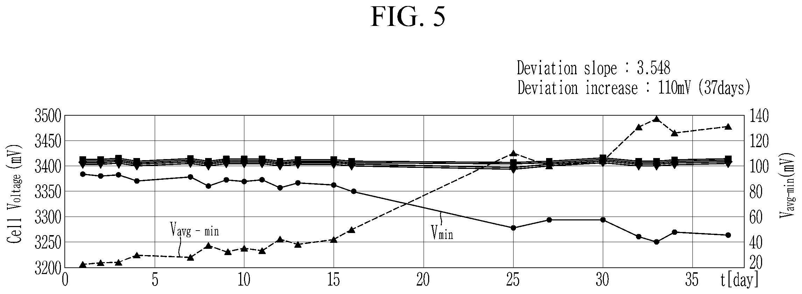

FIG. 5 is a graph illustrating a cell voltage change in a battery module in which an abnormal cell is occurred, and a change in the difference value (Vavg-min) between the average cell voltage value (Vavg) and the minimum cell voltage value (Vmin).

Referring to FIG. 5, a minimum cell voltage value (Vmin) of a battery module where an abnormal cell has occurred is in a state that it gradually decreases over time, dropping about 110 mV over 37 days. Accordingly, the difference value (Vavg-min) between the average cell voltage value (Vavg) and the minimum cell voltage value (Vmin) of the cell voltage values is gradually increased, and if the change in difference value (Vavg-min) over 37 days is an approximated as a linear function, it may be approximated as a linear function with a slope of 3.548.

Accordingly, the control device 53 may identify a battery module 111 in which abnormal cells will occur based on the rate of change (slope) of the difference value (Vavg-min) over time.

Meanwhile, even if the slope of the difference value (Vavg-min) satisfies the condition of being greater than 0.4, if the same battery cell does not satisfy the condition of maintaining the minimum cell voltage value within the battery module 111 throughout the data collection period, the control device 53 may exclude the battery module 111 from the abnormal cell detection target regardless of the slope of the difference value (Vavg-min). That is, the control device 53 may perform abnormal cell detection using the slope of the difference value (Vavg-min) only for the battery module 111 where the same battery cell maintained the minimum cell voltage value within the battery module 111 throughout the data collection period.

If an abnormal cell is detected, the control device 53 may perform protective operations according to the detection of the abnormal cell. For example, the control device 53 transmits diagnosis data including position information about abnormal cells (identification information of the battery module and battery rack to which the abnormal cell belongs) to the corresponding ESS 1, thereby performing the protective operation internally in the ESS 1. In addition, for example, the control device 53 may display diagnosis data including position information about abnormal cells (identification information of the battery module and battery rack to which the abnormal cell belongs) on an output device or may transmit the diagnosis data to a terminal such that the protective operation can be performed by an operator.

FIG. 2 for example illustrates the abnormal cell detection device 5 existing separately from the ESS 1 and may remotely perform abnormal cell diagnosis, but the embodiment may be modified to include abnormal cell detection device 5 within the ESS 1. For example, in another embodiment, the abnormal cell detection device 5 may be included in the BMS 20 or the EMS 30 of ESS 1, and the function of the abnormal cell detection device 5 described above may be performed by the BMS 20 or the EMS 30.

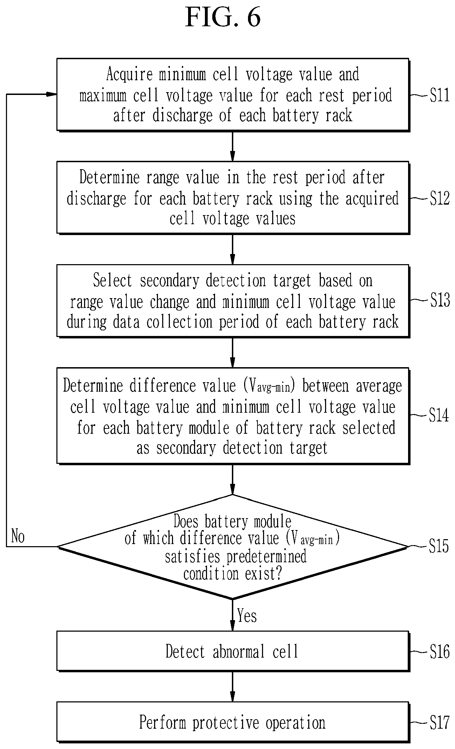

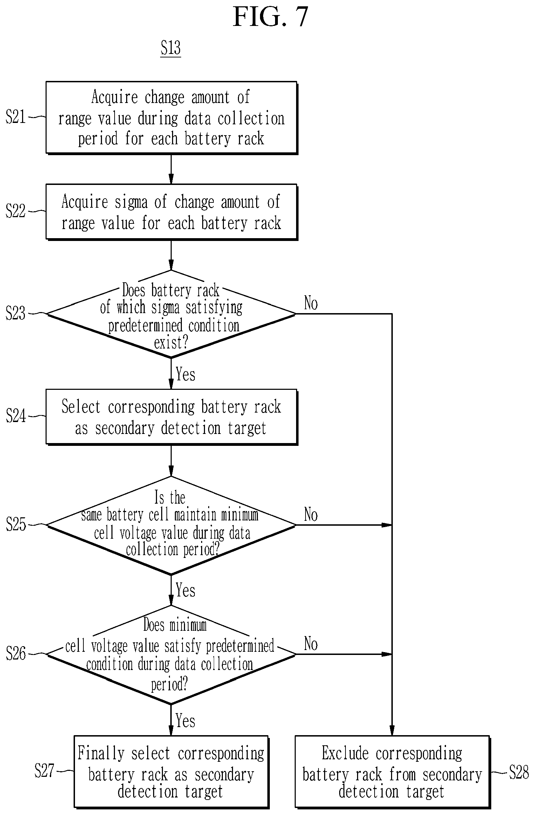

FIG. 6 is a flowchart of an abnormal cell detection method of the ESS according to an embodiment, and FIG. 7 is a detailed flowchart of the step S13 of FIG. 6. The method shown in FIG. 6 and FIG. 7 may be performed by the abnormal cell detection device 5 described above with reference to FIG. 2.

Referring to FIG. 6, the abnormal cell detection device 5 may acquire cell voltage values for the respective battery racks 11 constituting the battery bank 10 for each rest period after discharging of the battery bank 10 (step S11). The abnormal cell detection device 5 may store the cell voltage values obtained in this way in the storage device 52 by dividing them by a rest period (or date), a battery bank, a battery rack, and a battery module.

The abnormal cell detection device 5 may determine a range value (Vmax-min) in the rest period after discharge for each battery rack 11 using the cell voltage values acquired through the step S11 (step S12). The abnormal cell detection device 5 may calculate a difference between the maximum cell voltage value (Vmax) and the minimum cell voltage value (Vmin) among the cell voltage values detected in each rest period as a range value (Vmax-min) in the corresponding rest period.

If a range value (Vmax-min) for a rest period for each battery rack 11 is acquired, the abnormal cell detection device 5 may select a secondary detection target among battery racks 11 constituting the battery bank 10 based on a change in the range value (Vmax-min) and a change in a minimum cell voltage value (Vmin) of a data collection period of each battery rack 11 (step S13).

Referring to FIG. 7, the abnormal cell detection device 5 may acquire a change amount of the range value (Vmax-min) during the data collection period for each battery rack 11 for secondary detection target selection (step S21).

In step S21, the abnormal cell detection device 5 may calculate the amount of change in range value for each rest period by subtracting a range value (V'max-min) calculated in the previous rest period from the range value (Vmax-min) calculated in the corresponding rest period for each rest period. Then, as in Equation 1 above, the abnormal cell detection device 5 may cumulatively sum the calculated range value change for each rest period for each battery rack 11 during the data collection period, and may calculate a range value change ($\triangle$Vmax-min) during the data collection period for each battery rack 11.

If the range value change ($\triangle$Vmax-min) during the data collection period of each battery rack 11 is calculated, the abnormal cell detection device 5 may obtain a sigma of the range value change for each battery rack 11 using the range value change ($\triangle$Vmax-min) (step S22).

In step S22, the abnormal cell detection device 5 may calculate an average value and a standard deviation of the range value change ($\triangle$Vmax-min) of the entire battery rack 11 included in the battery bank 10 during the data collection period. Then, the abnormal cell detection device 5 may calculate a sigma of the amount of the change in range value ($\triangle$Vmax-min) of each battery rack 11 by substituting the average value and the standard deviation of the range value change of each battery rack 11 and the range value change ($\triangle$Vmax-min) of the entire battery rack 11 during the data collection period into Equation 2 above.

The abnormal cell detection device 5 may determine whether there is a battery rack 11 of which a sigma value obtained through step S22 satisfies a predetermined condition (e.g., sigma value > 4) (inquiry S23). If the abnormal cell detection device 5 detects the battery rack 11 of which a sigma value satisfies a predetermined condition, it may select the battery rack 11 as a secondary detection target (step S24).

The abnormal cell detection device 5 may additionally perform a verification process using the minimum cell voltage value for the battery rack 11 selected as a secondary detection target according to the sigma value.

First, the abnormal cell detection device 5 may determine whether the same battery cell maintained the minimum cell voltage value during the data collection period in the battery rack 11 selected as the secondary detection target (inquiry S25). If the same battery cell fails to maintain the minimum cell voltage value during the data collection period, the abnormal cell detection device 5 may exclude the battery rack 11 from the secondary detection target even if the sigma value satisfies the predetermined condition (step S28).

In addition, the abnormal cell detection device 5 may determine whether the minimum cell voltage value of the battery rack 11 selected as the secondary detection target satisfies the predetermined condition during the data collection period (inquiry S26).

In inquiry S26, the abnormal cell detection device 5 may approximate the change in minimum cell voltage value (Vmin) over time of the battery rack 11 selected as the secondary detection target using a slope of a linear function through a linear regression analysis. The abnormal cell detection device 5 checks whether the slope calculated in this way satisfies a predetermined condition (e.g., the condition of slope < -0.4), and if not satisfied, the battery rack 11 may be excluded from the secondary detection target (step S28).

On the other hand, if both the conditions in S25 and the conditions in S26 are satisfied, the abnormal cell detection device 5 may select the battery rack 11 as the secondary detection target (step S27).

Referring back to FIG. 6, the abnormal cell detection device 5 may determine a difference value (Vavg-min) between the average cell voltage value and the minimum cell voltage value for each battery module 111 constituting the battery rack 11 selected as the secondary detection target (step S14).

In step S14, the abnormal cell detection device 5 may select a valid rest period to be used in abnormal cell detection among rest periods performed during the data collection period for determination of the difference value (Vavg-min). To determine the valid rest period, the abnormal cell detection device 5 may set multiple voltage ranges by dividing the entire voltage range that the battery cell can output into predetermined intervals. In addition, the abnormal cell detection device 5 calculates the average cell voltage value for each battery module 111 using the remaining cell voltage values excluding the minimum cell voltage value for each rest period, and checks a voltage range in which an average cell voltage value for each rest period calculated in such a way is included, to thereby determine a voltage range corresponding to each rest period. The abnormal cell detection device 5 may group rest periods included in the same voltage range into the same voltage group if the voltage range corresponding to each rest period is determined. Then, the abnormal cell detection device 5 may determine whether there is a voltage group in which more than 50 % of the entire rest periods that occurred during the data collection period are included. If there is a voltage group in which more than 50 % of the entire rest periods are included, the abnormal cell detection device 5 may select rest periods included in the voltage group as valid rest periods target for the linear regression analysis.

In step S14, if a valid rest period for each battery module 111 is determined, the abnormal cell detection device 5 may calculate a difference value (Vavg-min) using the average cell voltage value (Vavg) and the minimum cell voltage value (Vmin) of cell voltage values only for each rest period selected as a valid rest period. In this case, the average cell voltage value (Vavg) may be a value calculated using the minimum cell voltage value (Vmin) or may be a value calculated using only the remaining cell voltage values excluding the minimum cell voltage value (Vmin).

If a difference value (Vavg-min) for each valid rest period for each battery module 111 is determined, the abnormal cell detection device 5 may determine whether a battery module 111 of which the determined difference value (Vavg-min) satisfies a predetermined condition exists (inquiry S15).

In inquiry S15, the abnormal cell detection device 5 may calculate a slope that indicates a change rate over time of the difference value (Vavg-min) by performing the linear regression analysis for the difference value (Vavg-min) calculated for each valid rest period. Then, the abnormal cell detection device 5 may determine that if the calculated slope is greater than a predetermined value (e.g., 0.4), the corresponding difference value (Vavg-min) satisfies a predetermined condition.

In inquiry S15, even if the slope of the difference value (Vavg-min) satisfies a predetermined condition, if the corresponding battery module 111 does not satisfy the condition that the same battery cell maintains the minimum cell voltage value throughout the data collection period, the abnormal cell detection device 5 may determine that the corresponding difference value (Vavg-min) does not satisfy a predetermined condition.

The abnormal cell detection device 5 may detect abnormal cells in the battery module 111 if there is a battery module 111 of which a difference value (Vavg-min) satisfies a predetermined condition (step S16). Then, the abnormal cell detection device 5 may perform protective operations according to abnormal cell detection (step S17).

According to the above-described embodiment, the abnormal cell detection device 5 is capable of early detection of abnormal cell occurrence by statistically analyzing a long-term voltage behavior of battery cells that form the battery bank 10. Therefore, it is possible to secure safety and reduce loss costs due to accidents by detecting abnormal cells early and performing protective operations before dangerous situations such as fire occur due to abnormal cells.

An electronic or electrical device and/or any other related device or constituent element according to the embodiments of the present disclosure described herein may include any suitable hardware, firmware (e.g., an application-specific integrated circuit), software, or may be implemented using a combination of software, firmware, and hardware. For example, various configurations of these devices may be formed on a single integrated circuit (IC) chip or on individual IC chips. In addition, various configurations of these devices may be implemented on a flexible printed circuit film, a tape carrier package (TCP), a printed circuit board (PCB), or a single substrate. The electrical connections or interconnections described in this specification may, for example, be implemented by wires or conductive elements on a PCB or other type of circuit carrier. The conductive devices may include, for example, surface metallizations, and/or pins, and may include conductive polymers or ceramics.

In addition, various configurations of these devices may be a process or thread run on one or more processors, within one or more computing devices, to execute computer program instructions and to interact with other system constituent elements to perform various functions described herein. The computer program instructions may be stored in a memory, which can be implemented in a computing device using a standard memory device such as a random access memory (RAM). The computer program instruction may also be stored on other non-transitory computer readable media, such as, for example, a CD-ROM, a flash drive, a disk drive, a solid state drive and the like.

Further, a person of ordinary skill in the art should be aware that functionality of various computing devices may be combined or integrated into a single computing device, or it may be distributed across one or more different computing devices while the functionality of a particular computing device without departing from the scope of the present invention, which is defined in the appended claims.

## Claims

**1.** An abnormal cell detection device (5) comprising:

a storage device (52) that stores cell voltage values detected for each rest period after discharge from a battery bank (10) including a plurality of battery racks (11); and
a control device (53) configured to:

determine a maximum cell voltage value (Vmax) and a first minimum cell voltage value in each battery rack (11) for each rest period;
determine a first difference value (Vmax-min) between the maximum cell voltage value (Vmax) and the first minimum cell voltage value in each battery rack (11) for each rest period;
select a target battery rack by statistically analyzing a change in the first difference value (Vmax-min) during a predetermined period;
determine a second difference value (Vavg-min) between an average cell voltage value (Vavg) and a second minimum cell voltage value in each battery module (111) of the target battery rack for each rest period; and
determine a battery module (111) including an abnormal cell in the target battery rack based on the second difference value (Vavg-min).

2. The abnormal cell detection device (5) as claimed in claim 1, wherein the control device (53) is further configured to:

> determine a first change amount of the first difference value (Vmax-min) by comparing with a previous rest period for each rest period; and calculate a second change amount in the first difference value (Vmax-min) during the predetermined period by cumulatively summing the first change amount determined for each rest period, wherein optionally the control device (53) is further configured to:
>
> > apply a weight value to the first change amount depending on whether the first change amount increases or decreases when cumulatively summing the first change amount; and
> > calculate the second change amount by cumulatively summing the first change amount to which the weight value is applied, and
>
> wherein further optionally the control device (53) is further configured to:
>
> > determine a sigma of the second change amount for each battery rack **(11)** based on the second change amount, an average value of the second change amount and a standard deviation of the second change amount of the plurality of battery racks **(11)** during the predetermined period; and
> > determine a battery rack **(11)** of which the sigma satisfies a predetermined condition as the target battery rack.

3. The abnormal cell detection device (5) as claimed in claim 1 or 2, wherein the control device (53) is further configured to exclude, from a selection of the target battery rack, a battery rack **(11)** in which the first minimum cell voltage value is not detected in the same battery cell during the predetermined period.

4. The abnormal cell detection device (5) as claimed in any preceding claim, wherein the control device (53) is further configured to:

> perform a linear regression analysis of the change in the first minimum cell voltage value for each battery rack **(11)** during the predetermined period; and
> exclude, from a selection of the target battery rack, a battery rack **(11)** of which a slope of the first minimum cell voltage value determined by the linear regression analysis does not satisfy a predetermined condition.

5. The abnormal cell detection device (5) as claimed in any preceding claim, wherein the control device (53) is further configured to:

> divide the entire output range of a battery cell into a plurality of voltage ranges;
> select a corresponding voltage range for each battery module (111) in the target battery rack among the plurality of voltage ranges for each rest period;
> if a number of rest periods in which the same voltage range is selected among rest periods occurred during the predetermined period is greater than or equal to a predetermined value, select rest periods in which the same voltage range is selected as a valid rest period; and
> determine a battery module (111) including the abnormal cell based on the second difference value (Vavg-min) of the valid rest period,
> wherein optionally the control device (53) is further configured to determine a voltage range in which the average cell voltage value (Vavg) of each battery module (111) belongs among the plurality of voltage ranges as the corresponding voltage range of each battery module (111), and
> wherein further optionally the average cell voltage value (Vavg) of each battery module (111) is an average value of remaining cell voltage values excluding the second minimum cell voltage value among cell voltage values detected in each battery module (111).

6. The abnormal cell detection device (5) as claimed in any preceding claim, wherein the control device (53) is further configured to:

> perform a linear regression analysis of the change in the second difference value (Vavg-min) for each battery module (111) of the target battery rack during the predetermined period; and
> determine a battery module (111) in which a slope of the second difference voltage (Vavg-min) determined by the linear regression analysis satisfies a predetermined condition as a battery module (111) including the abnormal cell.

7. The abnormal cell detection device (5) as claimed in any preceding claim, wherein the control device (53) is further configured to determine a battery cell in which the second minimum cell voltage value is detected within the battery module (111) including the abnormal cell as the abnormal cell.

8. The abnormal cell detection device (5) as claimed in any preceding claim, wherein the control device (53) is further configured to exclude a battery module (111) in which the battery cell of which the second minimum cell voltage value is detected is not the same during the predetermined period from abnormal cell detection.

9. An abnormal cell detection method of an energy storage system (ESS), comprising:

acquiring cell voltage values of each battery rack (11) included in a battery bank (10) in each rest period after discharge of the battery bank (10) (S11);
determining a maximum cell voltage value (Vmax) and a first minimum cell voltage value in each battery rack (11) for each rest period;
determining a first difference value (Vmax-min) between the maximum cell voltage value (Vmax) and the first minimum cell voltage value in each battery rack (11) for each rest period (S12);
selecting a target battery rack by statistically analyzing a change in the first difference value (Vmax-min) over a predetermined period (S13);
determining a second difference value (Vavg-min) between an average cell voltage value (Vavg) and a second minimum cell voltage value in each battery module (111) of the target battery rack for each rest period (S14); and
determining a battery module (111) including an abnormal cell in the target battery rack based on the second difference value (Vavg-min) (S16).

10. The abnormal cell detection method as claimed in claim 9, wherein:
the selecting the target battery rack includes:

determining a first change amount of the first difference value (Vmax-min) by comparing with a previous rest period for each rest period;
calculating a second change amount of the first difference value (Vmax-min) during the predetermined period by cumulatively summing the first change amount determined for each rest period (S21);
calculating an average value and a standard deviation of the second change amount for a plurality of battery racks (11) included in the battery bank (10) for the predetermined period;
determining a sigma of the second change amount for each battery rack (11) based on an average value of the second change amount, the standard deviation of the second change amount, and the second change amount (S22); and
determining a battery rack (11) of which the sigma satisfies a predetermined condition as the target battery rack (S23, S24), and
wherein optionally the calculating the second change amount includes:

applying a weight value to the first change amount according to whether the first change amount increases or decreases; and
calculating the second change amount by cumulatively summing the first change amount to which the weight value is applied.

11. The abnormal cell detection method as claimed in claim 9 or 10, further comprising excluding, from a selection of the target battery rack, a battery rack (11) in which the first minimum cell voltage value is not detected from the same battery cell during the predetermined period (S28).

12. The abnormal cell detection method as claimed in claim 9, 10 or 11, further comprising:

performing a linear regression analysis of the change in the first minimum cell voltage value for each battery rack (11) during the predetermined period; and
excluding, from a selection of the target battery rack, a battery rack (11) of which a slope of the first minimum cell voltage value determined by the linear regression analysis does not satisfy a predetermined condition (S28).

13. The abnormal cell detection method as claimed in any one of claims 9 to 12, wherein the determining the second difference value (Vavg-min) includes:

selecting, for each battery module (111) in the target battery rack, a corresponding voltage range among a plurality of voltage ranges divided at predetermined intervals for each rest period;

if a number of rest periods in which the same voltage range is selected among rest periods occurred during the predetermined period is greater than or equal to a predetermined value, selecting rest periods in which the same voltage range is selected as a valid rest period; and

determining a battery module (111) including the abnormal cell based on the second difference value (Vavg-min) of the valid rest period,

wherein optionally the selecting the corresponding voltage range includes, determining a voltage range in which the average cell voltage value (Vavg) of each battery module (111) belongs among the plurality of voltage ranges as the corresponding voltage range of each battery module (111), and

wherein further optionally the average cell voltage value (Vavg) of each battery module (111) is an average value of remaining cell voltage values excluding the second minimum cell voltage value among cell voltage values detected in each battery module (111).

14. The abnormal cell detection method as claimed in any one of claims 9 to 13, further comprising:

performing a linear regression analysis of the change in the second difference value (Vavg-min) for each battery module (111) of the target battery rack during the predetermined period; and

determining a battery module (111) in which a slope of the second difference value (Vavg-min) determined by the linear regression analysis satisfies a predetermined condition as a battery module (111) including the abnormal cell (S15).

15. The abnormal cell detection method as claimed in any one of claims 9 to 14, further comprising at least one of:

determining a battery cell in which the second minimum cell voltage value is detected within the battery module (111) including the abnormal cell as the abnormal cell; and

excluding a battery module (111) in which the battery cell of which the second minimum cell voltage value is detected is not the same during the predetermined period from abnormal cell detection (S28).

## Patentansprüche

1. Vorrichtung (5) zur Erkennung abnormaler Zellen, umfassend:

eine Speichervorrichtung (52), die die für jede Ruheperiode nach der Entladung aus einer Batteriebank (10) einschließlich einer Vielzahl von Batteriegestellen (11) erkannten Zellspannungswerte speichert; und

ein Steuereinrichtung (53), die zu Folgendem konfiguriert ist:

Bestimmen eines maximalen Zellspannungswerts (Vmax) und eines ersten minimalen Zellspannungswerts für jede Ruheperiode in jedem Batteriegestell (11).

Bestimmen eines ersten Differenzwerts (Vmax-min) zwischen dem maximalen Zellspannungswert (Vmax) und dem ersten minimalen Zellspannungswert für jede Ruheperiode in jedem Batteriegestell (11);

Auswählen eines Zielbatteriegestells durch statistische Analyse einer Änderung des ersten Differenzwertes (Vmax-min) während eines vorbestimmten Zeitraums;

Bestimmen eines zweiten Differenzwerts (Vavg-min) zwischen einem mittleren Zellspannungswert (Vavg) und einem zweiten minimalen Zellspannungswert für jede Ruheperiode in jedem Batteriemodul (111) des Zielbatteriegestells; und

Bestimmen eines Batteriemoduls (111), das eine fehlerhafte Zelle einschließt, im Zielbatteriegestell basierend auf dem zweiten Differenzwert (Vavg-min).

2. Vorrichtung (5) zur Erkennung abnormaler Zellen nach Anspruch 1, wobei die Steuereinrichtung (53) weiter zu Folgendem konfiguriert ist:

Bestimmen eines ersten Änderungsbetrags des ersten Differenzwertes (Vmax-min) für jede Ruheperiode durch Vergleich mit einer vorherigen Ruheperiode; und Berechnen eines zweiten Änderungsbetrags des ersten Differenzwertes (Vmax-min) während der vorbestimmten Periode durch kumulative Addition des für jede Ruheperiode bestimmten ersten Änderungsbetrags,

wobei die Steuereinrichtung (53) optional weiter zu Folgendem konfiguriert ist:

Anlegen eines Gewichtungswerts an den ersten Änderungsbetrag je nachdem, ob sich der erste Änderungsbetrag bei der kumulierten Addition erhöht oder verringert; und
Berechnen des zweiten Änderungsbetrags durch kumulierte Addition des ersten Änderungsbetrags, an den der Gewichtungswert angelegt wird, und

wobei die Steuereinrichtung (53) optional weiter zu Folgendem konfiguriert ist:

Bestimmen eines Sigma des zweiten Änderungsbetrags für jedes Batteriegestell (11) basierend auf dem zweiten Änderungsbetrag, einem Mittelwert des zweiten Änderungsbetrags und einer Standardabweichung des zweiten Änderungsbetrags der Vielzahl von Batteriegestellen (11) während des vorbestimmten Zeitraums; und
Bestimmen eines Batteriegestells (11), dessen Sigma eine vorbestimmte Bedingung erfüllt, als Zielbatteriegestell.

3. Vorrichtung (5) zur Erkennung abnormaler Zellen nach Anspruch 1 oder 2, wobei die Steuereinrichtung (53) weiter so konfiguriert ist, dass sie aus einer Auswahl des Zielbatteriegestells ein Batteriegestell (11) ausschließt, in dem der erste minimale Zellspannungswert in derselben Batteriezelle während des vorbestimmten Zeitraums nicht erkannt wird.

4. Vorrichtung (5) zur Erkennung abnormaler Zellen nach einem vorstehenden Anspruch, wobei die Steuereinrichtung (53) weiter zu Folgendem konfiguriert ist:

Durchführen einer linearen Regressionsanalyse der Änderung des ersten minimalen Zellspannungswerts für jedes Batteriegestell (11) während des vorbestimmten Zeitraums; und
Ausschließen des Batteriegestells (11) aus der Auswahl des Zielbatteriegestells, dessen Steigung des ersten minimalen Zellspannungswerts, die mittels linearer Regressionsanalyse bestimmt wurde, eine vorbestimmte Bedingung nicht erfüllt.

5. Vorrichtung (5) zur Erkennung abnormaler Zellen nach einem vorstehenden Anspruch, wobei die Steuereinrichtung (53) weiter zu Folgendem konfiguriert ist:

Aufteilen des gesamten Ausgangsspannungsbereichs einer Batteriezelle in eine Vielzahl von Spannungsbereichen;
Auswählen eines entsprechenden Spannungsbereichs für jedes Batteriemodul (111) im Zielbatteriegestell unter der Vielzahl von Spannungsbereichen für jede Ruheperiode;
wenn eine Anzahl von Ruheperioden unter den während des vorbestimmten Zeitraums aufgetretenen Ruheperioden, in denen derselbe Spannungsbereich ausgewählt wurde, einen vorbestimmten Wert erreicht oder überschreitet, Auswählen von Ruheperioden, in denen derselbe Spannungsbereich ausgewählt wurde, als gültige Ruheperiode; und
Bestimmen eines Batteriemoduls (111), das die abnormale Zelle einschließt, basierend auf dem zweiten Differenzwert (Vavg-min) der gültigen Ruheperiode,
wobei die Steuereinrichtung (53) optional weiter so konfiguriert ist, dass sie einen Spannungsbereich, in dem der mittlere Zellspannungswert (Vavg) jedes Batteriemoduls (111) zu der Vielzahl von Spannungsbereichen gehört, als entsprechenden Spannungsbereich jedes Batteriemoduls (111) bestimmt, und
wobei optional weiter der mittlere Zellspannungswert (Vavg) jedes Batteriemoduls (111) ein Mittelwert der verbleibenden Zellspannungswerte ist, wobei der zweite minimale Zellspannungswert unter den in jedem Batteriemodul (111) erkannten Zellspannungswerten ausgeschlossen wird.

6. Vorrichtung (5) zur Erkennung abnormaler Zellen nach einem vorstehenden Anspruch, wobei die Steuereinrichtung (53) weiter zu Folgendem konfiguriert ist:

Durchführen einer linearen Regressionsanalyse der Änderung des zweiten Differenzwertes (Vavg-min) für jedes Batteriemodul (111) des Zielbatteriegestells während des vorbestimmten Zeitraums; und
Bestimmen eines Batteriemoduls (111), bei dem die Steigung der zweiten Differenzspannung (Vavg-min), die durch die lineare Regressionsanalyse bestimmt wurde, eine vorgegebene Bedingung erfüllt, als Batteriemodul (111), das die abnormale Zelle einschließt.

7. Vorrichtung (5) zur Erkennung abnormaler Zellen nach einem vorstehenden Anspruch, wobei die Steuereinrichtung (53) weiter so konfiguriert ist, dass sie eine Batteriezelle, in der der zweite minimale Zellspannungswert innerhalb des Batteriemoduls (111), das die abnormale Zelle einschließt, erkannt wird, als die abnormale Zelle bestimmt.

8. Vorrichtung (5) zur Erkennung abnormaler Zellen nach einem vorstehenden Anspruch, wobei die Steuereinrichtung (53) weiter so konfiguriert ist, dass sie ein Batteriemodul (111), in dem die Batteriezelle, bei der der zweite minimale Zellspannungswert erkannt wird, während des vorbestimmten Zeitraums nicht derselbe ist, von der Erkennung abnormaler Zellen ausschließt.

9. Verfahren zur Erkennung abnormaler Zellen in einem Energiespeichersystem (ESS), umfassend:

Erhalten von Zellspannungswerten jedes in einer Batteriebank (10) enthaltenen Batteriegestells (11) in jeder Ruheperiode nach Entladung der Batteriebank (10) (S11);
Bestimmen eines maximalen Zellspannungswerts (Vmax) und eines ersten minimalen Zellspannungswerts für jede Ruheperiode in jedem Batteriefach (11);
Bestimmen eines ersten Differenzwerts (Vmax-min) zwischen dem maximalen Zellspannungswert (Vmax) und dem ersten minimalen Zellspannungswert für jede Ruheperiode in jedem Batteriegestell (11);
Auswählen eines Zielbatteriegestells durch statistische Analyse einer Änderung des ersten Differenzwertes (Vmax-min) über einen vorbestimmten Zeitraum (S13);
Bestimmen eines zweiten Differenzwerts (Vavg-min) zwischen einem mittleren Zellspannungswert (Vavg) und einem zweiten minimalen Zellspannungswert für jede Ruheperiode in jedem Batteriemodul (111) des Zielbatteriegestells (S14); und
Bestimmen eines Batteriemoduls (111), das eine abnormale Zelle einschließt, im Zielbatteriegestell basierend auf dem zweiten Differenzwert (Vavg-min).

10. Verfahren zur Erkennung abnormaler Zellen nach Anspruch 9, wobei:

das Auswählen des Zielbatteriegestells Folgendes einschließt:

Bestimmen eines ersten Änderungsbetrags des ersten Differenzwerts (Vmax-min) durch Vergleich mit einer vorherigen Ruheperiode für jede Ruheperiode;
Berechnen eines zweiten Änderungsbetrags des ersten Differenzwerts (Vmax-min) während des vorbestimmten Zeitraums durch kumulative Addition des für jede Ruheperiode bestimmten ersten Änderungsbetrags (S21);
Berechnen eines Mittelwerts und einer Standardabweichung des zweiten Änderungsbetrags für eine Vielzahl von Batteriegestellen (11), die in der Batteriebank (10) enthalten sind, für den vorbestimmten Zeitraum;
Bestimmen eines Sigma des zweiten Änderungsbetrags für jedes Batteriegestell (11) basierend auf einem Mittelwert des zweiten Änderungsbetrags, der Standardabweichung des zweiten Änderungsbetrags und dem zweiten Änderungsbetrag (S22); und
Bestimmen eines Batteriegestells (11), dessen Sigma eine vorbestimmte Bedingung erfüllt, als Zielbatteriegestell (S23, S24), und

wobei das Berechnen des zweiten Änderungsbetrags optional Folgendes einschließt:

Anlegen eines Gewichtungswerts an den ersten Änderungsbetrag je nachdem, ob sich der erste Änderungsbetrag erhöht oder verringert; und
Berechnen des zweiten Änderungsbetrags durch kumulierte Addition des ersten Änderungsbetrags, an den der Gewichtungswert angelegt wird.

11. Verfahren zur Erkennung abnormaler Zellen nach Anspruch 9 oder 10, weiter umfassend das Ausschließen eines Batteriegestells (11) aus einer Auswahl des Zielbatteriegestells, bei dem während des vorbestimmten Zeitraums von derselben Batteriezelle kein erster minimaler Zellspannungswert erkannt wird (S28).

12. Verfahren zur Erkennung abnormaler Zellen nach Anspruch 9, 10 oder 11, weiter umfassend:

Durchführen einer linearen Regressionsanalyse der Änderung des ersten minimalen Zellspannungswerts für jedes Batteriegestell (11) während des vorbestimmten Zeitraums; und
Ausschließen eines Batteriegestells (11) aus einer Auswahl des Zielbatteriegestells, bei dem eine Steigung des ersten minimalen Zellspannungswerts, die mittels linearer Regressionsanalyse bestimmt wurde, eine vorgegebene Bedingung nicht erfüllt (S28).

13. Verfahren zur Erkennung abnormaler Zellen nach einem der Ansprüche 9 bis 12, wobei das Bestimmen des zweiten Differenzwerts (Vavg-min) Folgendes einschließt:

Auswählen eines entsprechenden Spannungsbereichs unter der Vielzahl von Spannungsbereichen, die in vorbestimmten Intervallen unterteilt sind, für jede Ruheperiode für jedes Batteriemodul (111) im Zielbatteriegestell;

wenn eine Anzahl von Ruheperioden unter den während des vorbestimmten Zeitraums aufgetretenen Ruheperioden, in denen derselbe Spannungsbereich ausgewählt wurde, einen vorbestimmten Wert erreicht oder überschreitet, Auswählen von Ruheperioden, in denen der gleiche Spannungsbereich ausgewählt wurde, als gültige Ruheperiode; und

Bestimmen eines Batteriemoduls (111), das die abnormale Zelle einschließt, basierend auf dem zweiten Differenzwert (Vavg-min) der gültigen Ruheperiode,

wobei die Auswahl des entsprechenden Spannungsbereichs optional das Bestimmen eines Spannungsbereichs, in dem der mittlere Zellspannungswert (Vavg) jedes Batteriemoduls (111) zu der Vielzahlvon Spannungsbereichen gehört, als entsprechenden Spannungsbereich jedes Batteriemoduls (111) einschließt, und

wobei weiter optional der mittlere Zellspannungswert (Vavg) jedes Batteriemoduls (111) ein Mittelwert der verbleibenden Zellspannungswerte ist, wobei der zweite minimale Zellspannungswert unter den in jedem Batteriemodul (111) erkannten Zellspannungswerten ausgeschlossen wird.

14. Verfahren zur Erkennung abnormaler Zellen nach einem der Ansprüche 9 bis 13, weiter umfassend:

Durchführen einer linearen Regressionsanalyse der Änderung des zweiten Differenzwertes (Vavg-min) für jedes Batteriemodul (111) des Zielbatteriegestells während des vorbestimmten Zeitraums; und

Bestimmen eines Batteriemoduls (111), bei dem die Steigung des zweiten Differenzwertes (Vavg-min), der durch die lineare Regressionsanalyse bestimmt wurde, eine vorbestimmte Bedingung erfüllt, als ein Batteriemodul (111), das die abnormale Zelle (S15) einschließt.

15. Verfahren zur Erkennung abnormaler Zellen nach einem der Ansprüche 9 bis 14, weiter umfassend mindestens eines der Folgenden:

Bestimmen einer Batteriezelle, in der der zweite minimale Zellspannungswert erkannt wird, innerhalb des Batteriemoduls (111), das die abnormale Zelle einschließt, als die abnormale Zelle; und

Ausschließen eines Batteriemoduls (111), in dem die Batteriezelle, bei der der zweite minimale Zellspannungswert erkannt wird, während des vorbestimmten Zeitraums nicht derselbe ist, von der Erkennung einer abnormalen Zelle (S28).

**Revendications**

1. Dispositif de détection d'élément anormal (5) comprenant :

un dispositif de stockage (52) qui stocke les valeurs de tension d'élément détectées pour chaque période de repos après la décharge d'un banc de batteries (10) incluant une pluralité de racks de batterie (11) ; et
un dispositif de commande (53) configuré pour :

déterminer une valeur de tension d'élément maximale (Vmax) et une première valeur de tension d'élément minimale dans chaque rack de batterie (11) pour chaque période de repos ;
déterminer une première valeur de différence (Vmax-min) entre la valeur de tension d'élément maximale (Vmax) et la première valeur de tension d'élément minimale dans chaque rack de batterie (11) pour chaque période de repos ;
sélectionner un rack de batterie cible en analysant statistiquement un changement dans la première valeur de différence (Vmax-min) au cours d'une période prédéterminée ;
déterminer une seconde valeur de différence (Vavg-min) entre une valeur de tension d'élément moyenne (Vavg) et une seconde valeur de tension d'élément minimale dans chaque module de batterie (111) du rack de batterie cible pour chaque période de repos ; et
déterminer un module de batterie (111) incluant un élément anormal dans le rack de batterie cible en fonction de la seconde valeur de différence (Vavg-min).

2. Dispositif de détection d'élément anormal (5) selon la revendication 1, dans lequel le dispositif de commande (53) est en outre configuré pour :

déterminer une première quantité de changement de la première valeur de différence (Vmax-min) en la comparant à une période de repos précédente pour chaque période de repos ; et calculer une seconde quantité de changement de la première valeur de différence (Vmax-min) pendant la période prédéterminée en additionnant cumulativement la première quantité de changement déterminée pour chaque période de repos,

dans lequel optionnellement le dispositif de commande (53) est en outre configuré pour :

appliquer une valeur de pondération à la première quantité de changement selon que la première quantité de changement augmente ou diminue lors de l'addition cumulative de la première quantité de changement ; et calculer la seconde quantité de changement en additionnant cumulativement la première quantité de changement à laquelle la valeur de pondération est appliquée, et

dans lequel, en outre optionnellement, le dispositif de commande (53) est en outre configuré pour :

déterminer un sigma de la seconde quantité de changement pour chaque rack de batterie (11) en fonction de la seconde quantité de changement, d'une valeur moyenne de la seconde quantité de changement et d'un écart type de la seconde quantité de changement de la pluralité de racks de batterie (11) pendant la période prédéterminée ; et déterminer un rack de batterie (11) dont le sigma satisfait à une condition prédéterminée comme rack de batterie cible.

3. Dispositif de détection d'élément anormal (5) selon la revendication 1 ou 2, dans lequel le dispositif de commande (53) est en outre configuré pour exclure, d'une sélection du rack de batterie cible, un rack de batterie (11) dans lequel la première valeur de tension d'élément minimale n'est pas détectée dans le même élément de batterie pendant la période prédéterminée.

4. Dispositif de détection d'élément anormal (5) selon une quelconque revendication précédente, dans lequel le dispositif de commande (53) est en outre configuré pour :

effectuer une analyse de régression linéaire du changement de la première valeur de tension d'élément minimale pour chaque rack de batterie (11) au cours de la période prédéterminée ; et exclure, d'une sélection du rack de batterie cible, un rack de batterie (11) dont la pente de la première valeur de tension d'élément minimale déterminée par l'analyse de régression linéaire ne satisfait pas à une condition prédéterminée.

5. Dispositif de détection d'élément anormal (5) selon une quelconque revendication précédente, dans lequel le dispositif de commande (53) est en outre configuré pour :

diviser la plage de sortie complète d'un élément de batterie en une pluralité de plages de tension ; sélectionner une plage de tension correspondante pour chaque module de batterie (111) dans le rack de batterie cible parmi la pluralité de plages de tension pour chaque période de repos ; si un nombre de périodes de repos au cours desquelles la même plage de tension est sélectionnée parmi les périodes de repos survenues pendant la période prédéterminée est supérieur ou égal à une valeur prédéterminée, sélectionner des périodes de repos au cours desquelles la même plage de tension est sélectionnée comme période de repos valide ; et déterminer un module de batterie (111) incluant l'élément anormal en fonction de la seconde valeur de différence (Vavg-min) de la période de repos valide,

dans lequel le dispositif de commande (53) est en outre optionnellement configuré pour déterminer une plage de tension à laquelle la valeur de tension d'élément moyenne (Vavg) de chaque module de batterie (111) appartient parmi la pluralité de plages de tension en tant que plage de tension correspondante de chaque module de batterie (111), et

dans lequel, en outre, la valeur de tension d'élément moyenne (Vavg) de chaque module de batterie (111) est optionnellement une valeur moyenne des valeurs de tension d'élément restantes, à l'exclusion de la seconde valeur de tension d'élément minimale parmi les valeurs de tension d'élément détectées dans chaque module de batterie (111).

6. Dispositif de détection d'élément anormal (5) selon une quelconque revendication précédente, dans lequel le dispositif de commande (53) est en outre configuré pour :

effectuer une analyse de régression linéaire du changement de la seconde valeur de différence (Vavg-min) pour chaque module de batterie (111) du rack de batterie cible pendant la période prédéterminée ; et déterminer un module de batterie (111) dans lequel une pente de la seconde tension de différence (Vavg-min) déterminée par l'analyse de régression linéaire satisfait à une condition prédéterminée comme un module de batterie (111) incluant l'élément anormal.

7. Dispositif de détection d'élément anormal (5) selon une quelconque revendication précédente, dans lequel le dispositif de commande (53) est en outre configuré pour déterminer un élément de batterie dans lequel la seconde valeur de tension d'élément minimale est détectée dans le module de batterie (111) incluant l'élément anormal comme l'élément anormal.

8. Dispositif de détection d'élément anormal (5) selon une quelconque revendication précédente, dans lequel le dispositif de commande (53) est en outre configuré pour exclure un module de batterie (111) dans lequel l'élément de batterie dont la seconde valeur de tension d'élément minimale est détectée n'est pas le même pendant la période prédéterminée à partir de la détection d'élément anormal.

9. Procédé de détection d'élément anormal d'un système de stockage d'énergie (ESS), comprenant :

l'acquisition de valeurs de tension d'élément de chaque rack de batterie (11) inclus dans un banc de batteries (10) dans chaque période de repos après la décharge du banc de batteries (10) (S11) ; la détermination d'une valeur de tension d'élément maximale (Vmax) et d'une première valeur de tension d'élément minimale dans chaque rack de batterie (11) pour chaque période de repos ; la détermination d'une première valeur de différence (Vmax-min) entre la valeur de tension d'élément maximale (Vmax) et la première valeur de tension d'élément minimale dans chaque rack de batterie (11) pour chaque période de repos (S12) ; la sélection d'un rack de batterie cible en analysant statistiquement un changement dans la première valeur de différence (Vmax-min) sur une période prédéterminée (S13) ; la détermination d'une seconde valeur de différence (Vavg-min) entre une valeur de tension d'élément moyenne (Vavg) et une seconde valeur de tension d'élément minimale dans chaque module de batterie (111) du rack de batterie cible pour chaque période de repos (S14) ; et la détermination d'un module de batterie (111) incluant un élément anormal dans le rack de batterie cible en fonction de la seconde valeur de différence (Vavg-min) (S16).

10. Procédé de détection d'élément anormal selon la revendication 9, dans lequel :

la sélection du rack de batterie cible inclut :

la détermination d'une première quantité de changement de la première valeur de différence (Vmax-min) par comparaison avec une période de repos précédente pour chaque période de repos ; le calcul d'une seconde quantité de changement de la première valeur de différence (Vmax-min) pendant la période prédéterminée en additionnant cumulativement la première quantité de changement déterminée pour chaque période de repos (S21) ; le calcul d'une valeur moyenne et d'un écart type de la seconde quantité de changement pour une pluralité de racks de batterie (11) inclus dans le banc de batteries (10) pour la période prédéterminée ; la détermination d'un sigma de la seconde quantité de changement pour chaque rack de batterie (11) sur la base d'une valeur moyenne de la seconde quantité de changement, de l'écart type de la seconde quantité de changement et de la seconde quantité de changement (S22) ; et la détermination d'un rack de batterie (11) dont le sigma satisfait à une condition prédéterminée comme rack de batterie cible (S23, S24), et

dans lequel le calcul de la seconde quantité de changement inclut optionnellement :

l'application d'une valeur de pondération à la première quantité de changement selon que la première quantité de changement augmente ou diminue ; et

le calcul de la seconde quantité de changement en additionnant cumulativement la première quantité de changement à laquelle la valeur de pondération est appliquée.

11. Procédé de détection d'élément anormal selon la revendication 9 ou 10, comprenant en outre l'exclusion, d'une sélection du rack de batterie cible, d'un rack de batterie (11) dans lequel la première valeur de tension d'élément minimale n'est pas détectée à partir du même élément de batterie pendant la période prédéterminée (S28).

12. Procédé de détection d'élément anormal selon la revendication 9, 10 ou 11, comprenant en outre :

l'exécution d'une analyse de régression linéaire du changement de la première valeur de tension d'élément minimale pour chaque rack de batterie (11) au cours de la période prédéterminée ; et

l'exclusion, d'une sélection du rack de batterie cible, d'un rack de batterie (11) dont la pente de la première valeur de tension d'élément minimale déterminée par l'analyse de régression linéaire ne satisfait pas à une condition prédéterminée (S28).

13. Procédé de détection d'élément anormal selon l'une quelconque des revendications 9 à 12, dans lequel la détermination de la seconde valeur de différence (Vavg-min) inclut :

la sélection, pour chaque module de batterie (111) dans le rack de batterie cible, d'une plage de tension correspondante parmi une pluralité de plages de tension divisées à intervalles prédéterminés pour chaque période de repos ;

si un nombre de périodes de repos au cours desquelles la même plage de tension est sélectionnée parmi les périodes de repos survenues pendant la période prédéterminée est supérieur ou égal à une valeur prédéterminée, la sélection de périodes de repos au cours desquelles la même plage de tension est sélectionnée comme période de repos valide ; et

la détermination d'un module de batterie (111) incluant l'élément anormal en fonction de la seconde valeur de différence (Vavg-min) de la période de repos valide,

dans lequel la sélection de la plage de tension correspondante inclut optionnellement la détermination d'une plage de tension à laquelle la valeur de tension d'élément moyenne (Vavg) de chaque module de batterie (111) appartient parmi la pluralité de plages de tension en tant que plage de tension correspondante de chaque module de batterie (111), et

dans lequel, en outre, la valeur de tension d'élément moyenne (Vavg) de chaque module de batterie (111) est optionnellement une valeur moyenne des valeurs de tension d'élément restantes, à l'exclusion de la seconde valeur de tension d'élément minimale parmi les valeurs de tension d'élément détectées dans chaque module de batterie (111).

14. Procédé de détection d'élément anormal selon l'une quelconque des revendications 9 à 13, comprenant en outre :

l'exécution d'une analyse de régression linéaire du changement de la seconde valeur de différence (Vavg-min) pour chaque module de batterie (111) du rack de batterie cible pendant la période prédéterminée ; et

la détermination d'un module de batterie (111) dans lequel une pente de la seconde valeur de différence (Vavg-min) déterminée par l'analyse de régression linéaire satisfait à une condition prédéterminée comme un module de batterie (111) incluant l'élément anormal (S15).

15. Procédé de détection d'élément anormal selon l'une quelconque des revendications 9 à 14, comprenant en outre au moins une des étapes suivantes :

la détermination d'un élément de batterie dans lequel la seconde valeur de tension d'élément minimale est détectée au sein du module de batterie (111) incluant l'élément anormal comme élément anormal ; et

l'exclusion d'un module de batterie (111) dans lequel l'élément de batterie dont la seconde valeur de tension d'élément minimale est détectée n'est pas le même pendant la période prédéterminée à partir de la détection d'élément anormal (S28).

# FIG. 1

<u>1</u>

```
                                        ┌──────────┐
                                        │  System  │
                                        └──────────┘
                                             ↑↓
        ┌──────────┐                     ┌──────────┐
30──    │   EMS    │ ←──────────────→    │   PCS    │    ──40
        └──────────┘                     └──────────┘
             ↑↓                               │
        ┌──────────┐                          │
20──    │   BMS    │                          │
        └──────────┘                          │
             ↑↓                               ↕
    ┌──────────────────────────────────────────────────────┐
    │                    Battery bank                       │
    │   ┌──────────────────┐      ┌──────────────────┐      │
    │   │   Battery rack   │      │   Battery rack   │      │
    │   │ ┌──────────────┐ │      │ ┌──────────────┐ │      │
111─┼───┤ │Battery module│ │      │ │Battery module│ │      │
    │   │ ├──────────────┤ │ ...  │ ├──────────────┤ │      │
    │   │ │Battery module│ │      │ │Battery module│ │      │
    │   │ ├──────────────┤ │      │ ├──────────────┤ │      │
    │   │ │      ⋮       │ │      │ │      ⋮       │ │      │
    │   │ ├──────────────┤ │      │ ├──────────────┤ │      │
    │   │ │Battery module│ │      │ │Battery module│ │      │
    │   │ └──────────────┘ │      │ └──────────────┘ │      │
    │   └──────────────────┘      └──────────────────┘      │
    └──────────────────────────────────────────────────────┘
              11            10            11
```

# FIG. 2

EP 4 465 060 B1

# FIG. 3

# FIG. 4

FIG. 5

# FIG. 6

Acquire minimum cell voltage value and maximum cell voltage value for each rest period after discharge of each battery rack — S11

Determine range value in the rest period after discharge for each battery rack using the acquired cell voltage values — S12

Select secondary detection target based on range value change and minimum cell voltage value during data collection period of each battery rack — S13

Determine difference value ($V_{avg-min}$) between average cell voltage value and minimum cell voltage value for each battery module of battery rack selected as secondary detection target — S14

Does battery module of which difference value ($V_{avg-min}$) satisfies predetermined condition exist? — S15

No

Yes

Detect abnormal cell — S16

Perform protective operation — S17

# FIG. 7

S13

S21 — Acquire change amount of range value during data collection period for each battery rack

S22 — Acquire sigma of change amount of range value for each battery rack

S23 — Does battery rack of which sigma satisfying predetermined condition exist? — No

Yes

S24 — Select corresponding battery rack as secondary detection target

S25 — Is the same battery cell maintain minimum cell voltage value during data collection period? — No

Yes

S26 — Does minimum cell voltage value satisfy predetermined condition during data collection period? — No

Yes

S27 — Finally select corresponding battery rack as secondary detection target

S28 — Exclude corresponding battery rack from secondary detection target

# EP 4 465 060 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 113156318 A
- US 2022026499 A1
- US 2022376314 A1
- KR 20200000793 U